# FASCICULE DE BREVET EUROPEEN

(11) **EP 3 840 152 B1**
(45) Date de publication et mention de la délivrance du brevet: **25.02.2026**
(21) Numéro de dépôt: 20208084.2
(22) Date de dépôt: 17.11.2020
(51) Int. Cl.: H02G 3/12, H02G 3/14, H02G 3/16

(54) **SUPPORT D'APPAREILLAGE A MONTER DANS UNE PAROI DE FAIBLE EPAISSEUR ET MODULE D'APPAREILLAGE COMPORTANT UN TEL SUPPORT**
GERÄTEHALTERUNG FÜR DIE MONTAGE IN EINE WAND GERINGER DICKE, UND GERÄTEMODUL, DAS EINE SOLCHE HATLERUNG UMFASST
DEVICE SUPPORT TO BE MOUNTED IN A THIN WALL AND DEVICE MODULE COMPRISING SUCH SUPPORT

(30) Priorité: 16.12.2019 FR 1914463
(43) Date de publication de la demande: 23.06.2021
(73) Titulaire: Legrand France, 87000 Limoges (FR); Legrand SNC, 87000 Limoges (FR)
(72) Inventeur: RENARD, Stéphane, 72100 Le Mans (FR); HUIGNARD, Pascale, 72140 Le Grez (FR)
(74) Mandataire: Jacobacci Coralis Harle

(56) Documents cités:
- DE-A1- 10 020 216
- DE-A1- 19 632 536
- FR-A1- 2 762 941
- FR-A1- 3 013 159
- GB-A- 2 183 107

## Description

La présente invention concerne, de manière générale, l'encastrement de modules d'appareillage dans une paroi de divers mobiliers.

Elle trouve une application très avantageuse dans la réalisation d'un module d'appareillage à monter dans une paroi dont l'épaisseur est faible de l'ordre du millimètre.

Plus particulièrement, l'invention porte sur un support d'appareillage destiné à être rapporté dans une ouverture d'une paroi de réception, qui comprend :
à l'avant, un rebord défini entre une face avant et une face arrière,
à l'arrière, une paroi latérale qui s'étend à partir de la face arrière dudit rebord, sur une certaine hauteur, cette paroi latérale comportant au moins un conduit de guidage s'étendant sur au moins une partie de la hauteur de ladite paroi latérale, ledit conduit de guidage présentant une extrémité avant ouverte sur la face avant dudit rebord et, à l'opposé de ladite extrémité avant, une extrémité arrière éloignée dudit rebord, et
au moins un élément de fixation destiné à être enfilé dans ledit conduit de guidage, comportant, d'une part, à partir d'une extrémité proximale, une partie proximale qui se prolonge par une partie distale s'étendant jusqu'à une extrémité distale, ladite partie proximale étant apte à fléchir par rapport à ladite partie distale, et, d'autre part, une première partie d'accroche pour sa fixation audit support d'appareillage ainsi qu'une deuxième partie d'accroche pour sa fixation à ladite paroi de réception.

On connaît déjà notamment des documents US20060131046, US20140224533, EP2056418 et DE102013200405, des supports d'appareillage du type précité dans lesquels les éléments de fixation sont des brides flexibles. Ces brides portent, d'une part, à proximité de leur extrémité distale, un élément d'accroche à la paroi de réception dans laquelle est encastré ledit support d'appareillage, et, d'autre part, dans une région située à proximité de leur extrémité proximale, un ou plusieurs crans pour leur fixation au support d'appareillage.

Cette fixation par brides n'est pas fiable pour la fixation d'un tel support d'appareillage à une paroi de réception de faible épaisseur. En outre, elle ne permet pas le retrait et la mise en place de manière aisée du support d'appareillage dans la paroi de réception par l'avant d'une telle paroi.

Enfin, on connaît du document FR3013159, appartenant aux demanderesses, un support d'appareillage qui n'est pas destiné à s'accrocher sur le bord d'une ouverture pratiquée dans une paroi de réception mais qui est destiné à être fixé dans une boîte d'encastrement à l'aide de vis vissées dans des puits de vissage de cette boîte d'encastrement. Pour cela, selon ce document, il est prévu deux organes de fixation. Chaque organe de fixation est une lame avec une languette et une patte articulée sur la languette par une liaison formant charnière. Il est prévu dans la languette de chaque organe de fixation une découpe formant une dent d'accrochage. En outre, l'extrémité libre de la patte comporte une encoche en U. Lorsque la languette de l'organe de fixation est engagée par glissement dans une fente de guidage ou de passage prévue dans une sorte de paroi latérale portée par le support d'appareillage, la dent d'accrochage s'accroche sur un cran de cette fente de guidage. De manière concomitante, l'extrémité libre de la patte formant l'encoche de chaque organe de fixation reste, en position déployée dite de repos, en retrait de ladite ouverture latérale et dudit rebord périphérique du support d'appareillage. Cette ouverture latérale du support d'appareillage est destinée à accueillir la vis dont le fût se loge dans l'encoche de la patte de l'organe de fixation de sorte que l'extrémité libre de la patte se place derrière la tête de la vis. La fixation du support d'appareillage est réalisée par vissage des vis dans les fûts de la boîte d'encastrement pour coincer chaque patte entre la tête de chaque vis et le bord du fût de vissage correspondant.

Un tel support est relativement complexe et n'est pas du tout adapté à un montage direct dans une ouverture d'une paroi de réception de fine épaisseur.

Afin de remédier aux inconvénients de l'état de la technique, la présente invention propose un support d'appareillage tel que défini dans la revendication 1.

Avantageusement, grâce à l'invention, le support d'appareillage peut être mis en place aisément sans outil par l'installateur dans l'ouverture de réception d'une paroi de faible épaisseur, de l'ordre du millimètre. Il suffit à l'installateur de placer la paroi latérale du support d'appareillage dans ladite ouverture de réception de sorte que la face arrière dudit rebord de ce support d'appareillage repose sur ladite paroi, autour de l'ouverture de réception, puis d'enfiler chaque élément de fixation dans le conduit de guidage correspondant de la paroi latérale pour que la première dent portée par sa partie distale s'accroche au cran dudit conduit de guidage et que la deuxième dent portée par sa partie proximale s'accroche sous la paroi. Ledit support d'appareillage est alors maintenu dans ladite ouverture de réception en prenant en sandwich ladite paroi, autour de ladite ouverture de réception, entre le rebord dudit support d'appareillage et la deuxième dent de chaque élément de fixation accroché dans chaque conduit de guidage de la paroi latérale dudit support d'appareillage.

D'autres caractéristiques non limitatives et avantageuses du support d'appareillage conforme à l'invention, prises individuellement ou selon toutes les combinaisons techniquement possibles, sont définies dans les revendications 2 à 10.

L'invention propose également un module d'appareillage comportant un support d'appareillage tel que décrit précédemment et au moins un mécanisme d'appareillage monté dans ledit support d'appareillage de sorte qu'une partie fonctionnelle de chaque mécanisme d'appareillage est entourée par le rebord de ce dernier.

La description qui va suivre en regard des dessins annexés, donnés à titre d'exemples non limitatifs, fera bien comprendre en quoi consiste l'invention et comment elle peut être réalisée.

Sur les dessins annexés :
la figure 1 est une vue schématique en perspective éclatée d'un mode de réalisation préférentiel d'un module d'appareillage conforme à l'invention,
la figure 2 est une vue schématique en perspective d'une phase de montage du module d'appareillage de la figure 1 dans l'ouverture d'une paroi de réception,
la figure 3 est une vue schématique en perspective assemblée du module d'appareillage de la figure 1 avec les éléments de fixation de son support d'appareillage en position d'accrochage,
la figure 4 est une vue schématique en perspective arrière du module d'appareillage de la figure 3 avec sa rondelle prête à être mise en place par l'arrière sur la paroi latérale du support d'appareillage,
la figure 5 est une vue similaire à celle de la figure 4 avec la rondelle en place sur la paroi latérale dudit support d'appareillage,
la figure 6 est une vue schématique de la face avant du module d'appareillage de la figure 3,
la figure 7 est une vue schématique de la face arrière d'une rondelle de finition du module d'appareillage de la figure 1,
la figure 8 est une vue en coupe selon le plan A-A de la figure 6 avec la matérialisation de la paroi de réception dans laquelle est encastré le module d'appareillage avec les éléments de fixation de son support d'appareillage en position désengagée pour le démontage dudit module d'appareillage,
la figure 9 est une vue en coupe selon le plan A-A de la figure 6 avec la matérialisation de la paroi de réception dans laquelle est encastré le module d'appareillage,
la figure 10 est une vue en coupe selon le plan B-B de la figure 6 avec la matérialisation de la paroi de réception dans laquelle est encastré le module d'appareillage avec les éléments de fixation de son support d'appareillage en position désengagée pour le démontage dudit module d'appareillage, et
la figure 11 est une vue en coupe selon le plan B-B de la figure 6 avec la matérialisation de la paroi de réception dans laquelle est encastré le module d'appareillage.

Dans la description qui va suivre, par convention, le terme « avant » désignera le côté d'un élément décrit orienté vers un utilisateur lorsque cet élément est en position d'utilisation sur un support de réception, tandis que le terme « arrière » désignera le côté opposé de cet élément, tourné vers l'intérieur de ce support.

En outre, dans la description qui va suivre, par convention, le terme «proximal » désignera le côté d'un élément décrit situé au plus près d'un utilisateur lorsque cet élément est en position d'utilisation sur un support de réception, tandis que le terme « distal » désignera le côté opposé de cet élément, situé au plus loin de l'utilisateur.

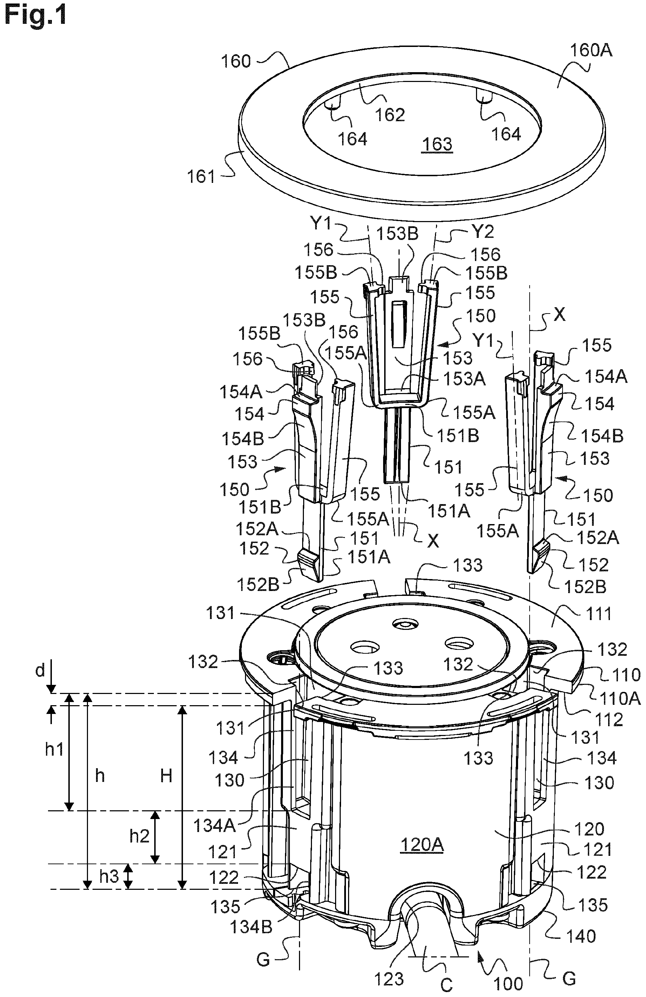

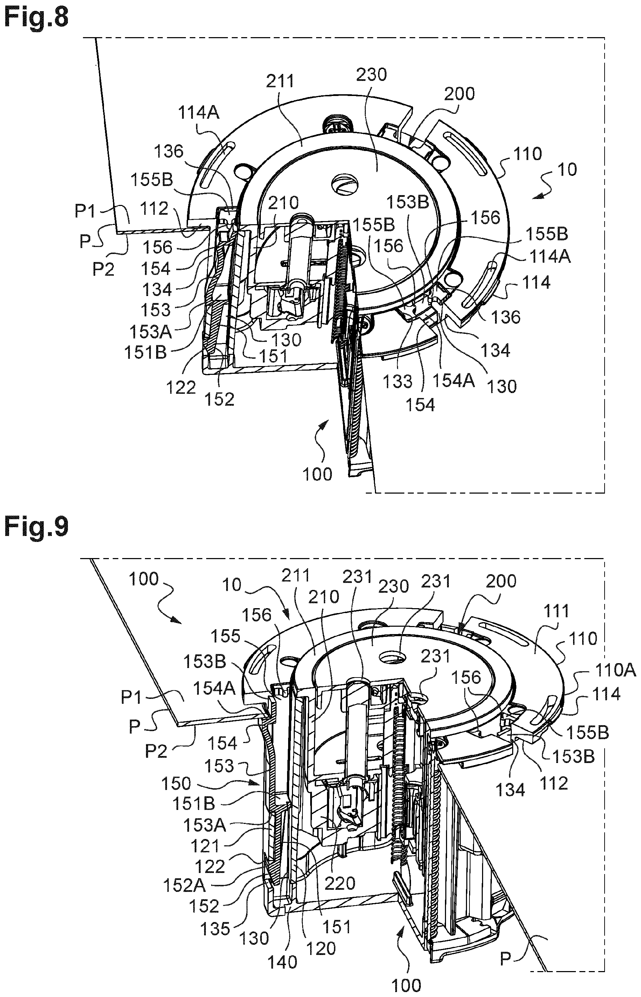

Sur les figures 1 à 11, on a représenté un module d'appareillage 10 à encastrer dans une ouverture d'une paroi de réception P (voir les figures 8 à 11).

Grâce à son support d'appareillage 100, qui va être décrit très en détail dans la suite du texte, le module d'appareillage 10 représenté, est, avantageusement, adapté à être monté dans une paroi de réception P de faible épaisseur comprise entre 0,8 et 1,2 millimètres.

Cette paroi de réception P de faible épaisseur peut être une tôle métallique comme celles constituant des étagères ou des casiers de rangement ou de vestiaires, tels que ceux qui permettent la recharge d'un téléphone portable pendant la durée d'une activité.

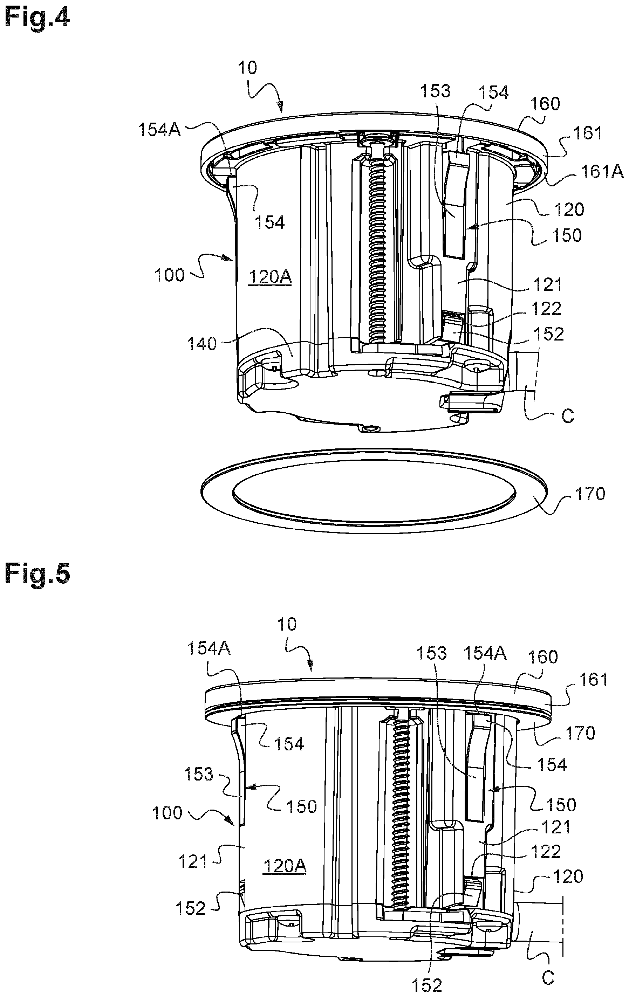

Pour pouvoir également être monté dans des parois de mobilier plus épaisses, le support d'appareillage 100 est équipé de moyens complémentaires de montage (non décrits mais visibles sur les figures 4 et 5), constitués classiquement de deux sous-ensembles griffe/vis sans fin.

Le support d'appareillage 100 est aussi particulièrement adapté à une paroi de structure d'un mobilier d'assise comme un fauteuil ou un canapé qui comporte une structure rigide recouverte d'un matériau souple.

Le module d'appareillage 10 représenté est ici un module monoposte qui comporte un seul mécanisme d'appareillage 200 mais, selon d'autres variantes non représentées, il pourrait s'agir d'un module multipostes comportant plusieurs mécanismes d'appareillage montés côte à côte dans un même support d'appareillage.

Comme le montrent plus particulièrement les figures 1 et 8 à 11, le module d'appareillage 10 comporte un support d'appareillage 100 et un mécanisme d'appareillage 200 monté dans ledit support d'appareillage 100 de sorte que la partie fonctionnelle 230 de ce mécanisme soit accessible à un utilisateur en face avant dudit module d'appareillage 10.

Le mécanisme d'appareillage 200 est ici un mécanisme de prise de courant classique du type franco-belge.

Pour l'essentiel, il comprend un socle en matière isolante, présentant deux parties assemblées entre elles dont une partie arrière 220 enfermant trois bornes électriques, une borne de phase, une borne de neutre et une borne de terre raccordée à une broche de terre 250.

La partie arrière 220 du socle comporte une ouverture avant fermée par la paroi de fermeture d'une partie avant 210 du socle, solidarisée à la partie arrière 220.

Cette partie avant 210 comporte une paroi latérale cylindrique qui délimite avec ladite paroi de fermeture, un puits cylindrique d'insertion d'une fiche électrique.

La paroi de fermeture de la partie avant 210 est percée de trois ouvertures. Deux de ces trois ouvertures donnent accès aux alvéoles des bornes de phase et de neutre logées dans la partie arrière 220 du socle et la troisième est traversée par la broche de terre 250 connectée à la borne de terre dans la partie arrière 220 du socle.

La broche de terre 250 émerge alors dans le puits cylindrique de la partie avant 210.

A l'arrière, ladite partie arrière 220 du socle comporte des ouvertures d'accès aux bornes électriques. Des fils électriques provenant d'un câble d'alimentation C tiré du réseau électrique, sont introduits au travers de ces ouvertures arrière et connectés aux bornes électriques pour l'alimentation dudit mécanisme de prise de courant 200.

A l'avant, la paroi latérale cylindrique de la partie avant 210 du socle est bordée d'une collerette externe 211 ici circulaire. La collerette externe 211 forme un moyen de montage du socle du mécanisme d'appareillage 200 dans le support d'appareillage 100 du module d'appareillage 10.

Le mécanisme de prise de courant 200 ici représenté est un mécanisme pourvu d'une paroi de piston 230 circulaire, mobile entre, d'une part, une position d'attente dans laquelle cette paroi de piston 230 ferme le puits cylindrique de la partie avant 210, en venant à effleurement de la face avant de ladite collerette externe 211, comme cela est représenté sur les figures 8 à 11, et, d'autre part, une position d'utilisation dans laquelle cette paroi de piston 230 est enfoncée par la fiche électrique insérée dans le puits. De manière connue, cette paroi de piston 230 est rappelée en permanence en position d'attente par un ressort interne (non référencé mais visible sur les figures 8 à 11). Cette paroi de piston 230 est percée de trois ouvertures circulaires 231 (voir figure 9). Deux de ces trois ouvertures 231 donnent aux broches de la fiche électrique accès aux alvéoles des bornes de phase et de neutre du mécanisme de prise de courant 200 et la troisième ouverture est traversée par la broche de terre 250 du mécanisme de prise de courant 200 lors de l'enfoncement de la paroi de piston 230 pour que cette broche de terre 250 s'insère dans la borne de terre prévue dans la fiche électrique.

Ce mécanisme de prise de courant 200 étant bien connu en soi, il ne sera pas décrit plus en détails ici.

D'ailleurs, selon d'autres variantes non représentées du module d'appareillage conforme à l'invention, on pourra prévoir d'autres standards de prise de courant, d'autres types de mécanisme d'appareillage comme un mécanisme de prise USB ou de prise RJ ou de prise téléphone ou de prise de courant dont le fond du puits est fixe ou encore un mécanisme de commutateur quelconque ou un mécanisme de commande quelconque.

Le support d'appareillage 100 du module d'appareillage 10 comprend, à l'avant, un rebord 110 externe défini entre une face avant 111 et une face arrière 112, et, à l'arrière, une paroi latérale 120 qui s'étend à partir de la face arrière 112 dudit rebord 110, sur une certaine hauteur H (voir figure 1).

Le rebord 110 et la paroi latérale 120 du support d'appareillage 100 appartiennent à une seule pièce monobloc avantageusement moulée en matière plastique.

Le rebord 110 présente une tranche externe 110A ici circulaire. La paroi latérale 120 est globalement une paroi cylindrique de révolution. Le rebord 110 longe le bord avant de cette paroi latérale 120 et il forme une collerette annulaire qui déborde de la face externe 120A cylindrique de cette paroi latérale 120.

Comme le montre la figure 1, le rebord 110 présente une épaisseur d et la paroi latérale 120 s'étend à l'arrière sur une hauteur H bien supérieure à cette épaisseur d.

La paroi latérale 120 délimite intérieurement un logement interne dans lequel est monté le socle du mécanisme d'appareillage 200. Ce logement interne est ouvert à l'avant. L'ouverture avant de ce logement interne présente un contour circulaire formé par la tranche interne du rebord 110.

Comme le montrent notamment les figures 8 à 11, la collerette externe 211 du socle du mécanisme d'appareillage 200 monté dans le logement interne du support d'appareillage 100, repose sur la face avant 111 du rebord 110 dudit support d'appareillage 100 afin de retenir vers l'arrière le socle du mécanisme d'appareillage 200 sur le support d'appareillage 100. Il est prévu par ailleurs des aménagements internes (non visibles sur les figures) de la paroi latérale 120 du support d'appareillage 100, qui coopèrent avec des aménagements complémentaires (non visibles sur les figures) du socle du mécanisme d'appareillage 200 pour retenir vers l'avant le socle du mécanisme d'appareillage 200 sur le support d'appareillage 100.

A l'arrière, le logement interne du support d'appareillage 100 est fermé par un capot 140 rapporté sur le bord arrière de la paroi latérale 120 du support d'appareillage 100. Le capot 140 est pièce avantageusement réalisée en matière plastique moulée. Il est maintenu sur la paroi latérale 120 par des vis vissées au travers des ouvertures du capot 140 dans des conduits taraudés de cheminées prévues sur la face interne de cette paroi latérale 120.

Un embout cylindrique 123 est rapporté dans une encoche prévue dans le bord arrière de la paroi latérale 120 et dans une ouverture latérale du capot 140 mise en concordance de cette encoche, pour l'entrée d'une extrémité du câble d'alimentation C à l'intérieur du logement interne du support d'appareillage 100 (voir figure 1 par exemple).

Comme le montrent plus particulièrement les figures 1 à 3 et 6, la paroi latérale 120 du support d'appareillage 100 comporte au moins un conduit de guidage 130 s'étendant sur au moins une partie de la hauteur H de ladite paroi latérale 120.

Ici, ladite paroi latérale 120 comporte trois conduits de guidage 130 qui s'étendent selon trois génératrice G de la paroi latérale 120. Ces conduits de guidage 130 sont répartis régulièrement sur le pourtour de la paroi latérale 120 mais, selon une autre variante non représentée, on pourrait prévoir qu'elle ne comporte que deux conduits de guidage positionnés de manière diamétralement opposés.

Chaque conduit de guidage 130 présente une extrémité avant 133 ouverte sur la face avant 111 dudit rebord 110 du support d'appareillage 100 et, à l'opposé de ladite extrémité avant 133, une extrémité arrière 135 éloignée dudit rebord 110.

Chaque conduit de guidage 130 comporte un cran 122 situé à proximité de son extrémité arrière 135 et une ouverture latérale 134 située au moins à proximité de son extrémité avant 133, juste en dessous de la face arrière 112 dudit rebord 110 du support d'appareillage 100.

Préférentiellement, chaque conduit de guidage 130 est formé par une rainure prévue en renfoncement de la face externe 120A de la paroi latérale 120.

Cette rainure 130 est ouverte latéralement sur la face externe 120A de ladite paroi latérale 120. Elle présente un profil rectangulaire et elle débouche sur la face avant 111 dudit rebord 110 par une ouverture d'extrémité 133 de section rectangulaire (voir figure 1).

Chaque rainure 130 est délimitée par deux faces longitudinales 131 en regard l'une de l'autre et par deux faces latérales 132 en regard l'une de l'autre. L'une des faces longitudinales 131 de chaque rainure 130, celle située du côté de la face externe 120A de la paroi latérale 120, est fendue sur sa hauteur h par ladite ouverture latérale 134 débouchant à l'extérieur du support d'appareillage 100. L'ouverture latérale 134 de chaque conduit de guidage 130 présente une largeur plus faible que la longueur de la face longitudinale 131 correspondante de ce conduit. L'ouverture latérale 134 s'étend depuis la face avant 111 dudit rebord 110, au travers de l'épaisseur d de ce dernier, puis sur toute la hauteur H de la paroi latérale 120. Elle présente donc une longueur h égale à la somme de l'épaisseur d du rebord 110 et de la hauteur H de la paroi latérale 120 du support d'appareillage 100 (voir figure 1).

L'ouverture latérale 134 de chaque conduit de guidage 130 est, à proximité de l'extrémité arrière 135 dudit conduit de guidage, partiellement fermée sur une longueur h2 par une partie 121 de la paroi latérale 120. Cette ouverture latérale 134 comprend alors deux parties 134A, 134B séparées par ladite partie 121 de ladite paroi latérale 120, à savoir une partie avant 134A s'étendant sur une longueur h1 depuis l'ouverture d'extrémité avant 133 de ladite rainure 130 jusqu'à un bord avant de cette partie 121 de ladite paroi latérale 120 et une partie arrière 134B s'étendant sur une longueur h3, largement inférieure h1, depuis un bord arrière 122 de cette partie 121 de ladite paroi latérale 120 jusqu'à l'extrémité arrière 135 de ladite rainure 130, ledit bord arrière formant ledit cran 122 dudit conduit de guidage 130.

Selon l'invention, le support d'appareillage 100 comprend un élément de fixation 150 destiné à être enfilé dans chaque conduit de guidage 130.

Il est donc prévu ici trois éléments de fixation 150 à enfiler dans les trois conduits de guidage 130 de la paroi latérale 120.

Comme le montre la figure 1, chaque élément de fixation 150 est une sorte d'agrafe allongée suivant un axe X. C'est avantageusement une pièce monobloc réalisée par moulage d'une matière plastique. Chaque élément de fixation 150, comporte, d'une part, à partir d'une extrémité proximale 153B, une partie proximale 153 qui se prolonge par une partie distale 151 s'étendant jusqu'à une extrémité distale 151A, ladite partie proximale 153 étant apte à fléchir par rapport à ladite partie distale 151, et, d'autre part, une première partie d'accroche 152 pour sa fixation audit support d'appareillage 100 ainsi qu'une deuxième partie d'accroche 154 pour sa fixation à ladite paroi de réception P.

La première partie d'accroche 152 de chaque élément de fixation 150 comporte une première dent 152A portée par ladite partie distale 151 à proximité immédiate de ladite extrémité distale 151A et la deuxième partie d'accroche 154 de chaque élément de fixation 150 comporte une deuxième dent 154A portée par ladite partie proximale 153 à proximité immédiate de ladite extrémité proximale 153B.

Comme le montrent bien les figures 1 et 9, la partie distale 151 de chaque élément de fixation 150 est une pièce allongée qui s'étend selon l'axe X à partir d'une plate-forme rigide intermédiaire 151B à laquelle elle est attachée de manière rigide et la partie proximale 153 est une pièce allongée selon l'axe X, attachée par une charnière de pivotement à ladite plate-forme rigide intermédiaire 151B.

La partie distale 151 s'étend à partir d'une face arrière de ladite plate-forme rigide intermédiaire 151B perpendiculairement à celle-ci et la partie proximale 153 s'étend en porte-à-faux de cette plate-forme intermédiaire 151B à partir d'un bord de celle-ci auquel elle est raccordée par la charnière de pivotement 153A.

La partie distale 151 et la partie proximale 153 de chaque élément de fixation 150 sont deux languettes rigides dont des faces orientées d'un même côté portent, respectivement, les première et deuxième dents 152A, 154A, chacune des première et deuxième dents 152A, 154A étant raccordée à ladite face de la languette 151, 153 correspondante par une rampe d'engagement inclinée 152B, 154B.

La longueur de chaque élément de fixation 150 est sensiblement égale à la longueur de chaque conduit de guidage 130. Chaque élément de fixation 150 présente par exemple une longueur de l'ordre de 45 millimètres. La largeur de chaque languette rigide 151, 153 de chaque élément de fixation 150 est égale au jeu près à la largeur de l'ouverture latérale 134 de chaque conduit de guidage 130. Cette largeur est par exemple de l'ordre de 5 millimètres. Chaque languette rigide présente une épaisseur de l'ordre du millimètre. Chaque rampe d'engagement 152B, 154B est inclinée d'un angle d'environ 20 degrés par rapport à la face de ladite languette rigide 151, 153 qui la porte. La surface d'accrochage de la première dent 152A forme par exemple un angle de 60 degrés avec la face de la languette rigide 151 qui la porte alors que la surface d'accrochage de la deuxième dent 154A forme un angle droit avec la face de la languette rigide 153 qui la porte. La languette rigide 153 qui forme la partie proximale de chaque élément de fixation 150 présente une longueur, égale ici à environ 27 millimètres, supérieure à celle (de l'ordre de 18 millimètres) de la languette rigide 151 formant la partie distale de chaque élément de fixation 150.

La charnière de pivotement de la partie proximale 153 est réalisée par un coude qui relie la languette rigide 153 au bord de ladite plate-forme intermédiaire 151B.

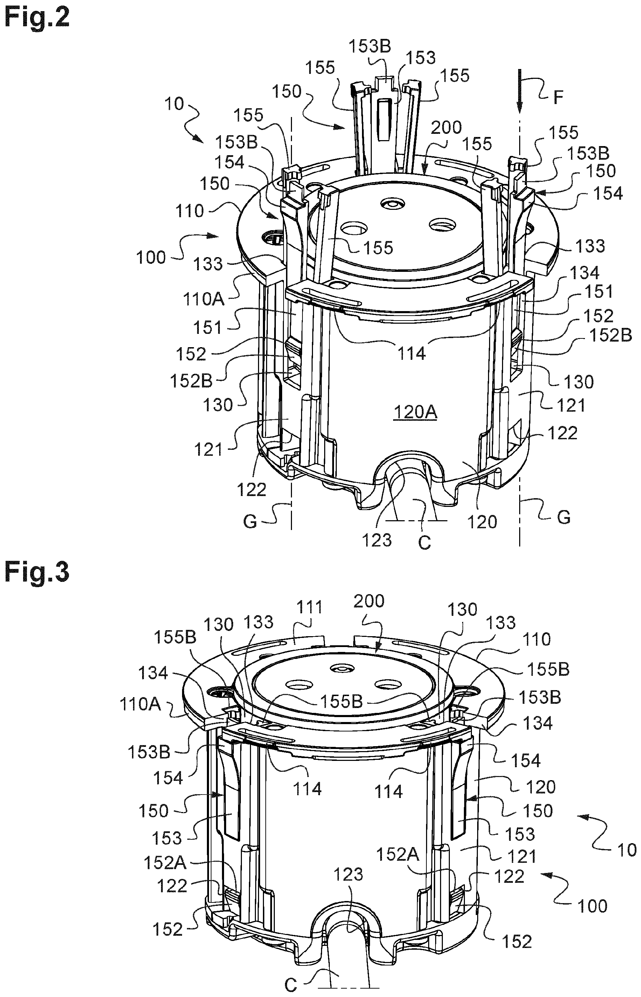

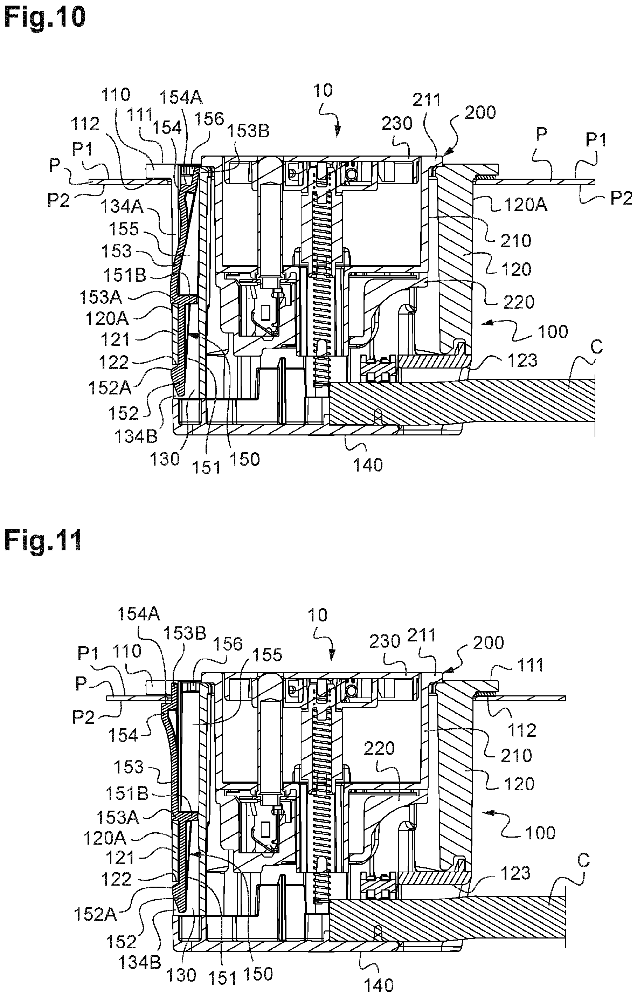

Chaque élément de fixation 150 est adapté à être enfilé selon la flèche F (voir figure 2) dans chaque conduit de guidage 130 via ladite extrémité avant 133 de celui-ci de sorte que ladite première dent 152A dudit élément de fixation 150 s'accroche audit cran 122 dudit conduit de guidage 130 et que ladite deuxième dent 154A dudit élément de fixation 150 fait saillie sur ladite paroi latérale 120 du support d'appareillage 100, au travers de ladite ouverture latérale 134 dudit conduit de guidage 130, juste en dessous de la face arrière 112 dudit rebord 110 (voir figures 9 et 11).

Il est prévu des moyens de retenue débrayables aptes à maintenir la deuxième dent 154A de chaque élément de fixation 150 en retrait de ladite ouverture latérale 134 dudit conduit de guidage 130 (voir figures 8 et 10).

Ces moyens de retenue comprennent des moyens élastiquement déformables.

Selon l'exemple préférentiel représenté sur les différentes figures, lesdits moyens de retenue appartiennent audit élément de fixation 150.

Plus particulièrement, lesdits moyens de retenue comprennent au moins un téton 156 apte à se plaquer contre une languette de manœuvre rigide 153B formant l'extrémité proximale de la partie proximale 153 dudit élément de fixation 150 (voir figure 1).

Selon le mode de réalisation représenté sur les figures, chaque élément de fixation 150 comporte, d'une part, deux barrettes rigides 155 qui s'étendent globalement dans la même direction que la partie proximale 153, à partir de deux autres bords parallèles de ladite plate-forme rigide intermédiaire 151B, en étant reliées à ceux-ci par des charnières de pivotement 155A, chaque barrette 155 portant, à proximité de son extrémité proximale libre 155B, un téton 156 sur une face en regard de l'autre barrette 155, et, d'autre part, une languette de manœuvre 153B formant ladite extrémité proximale de ladite partie proximale 153, les tétons 156 portés par lesdites barrettes 155 étant aptes à s'appliquer contre ladite languette de manœuvre 153B lors d'une flexion de la charnière de pivotement 153A de ladite partie proximale 153 et desdites charnières de pivotement 155A desdites barrettes 155.

Comme le montre la figure 1, les deux barrettes 155 s'étendent suivant deux axes Y1 et Y2 inclinés par rapport audit axe X des languettes rigides 151, 153 et formant un angle aigu entre eux, par exemple de l'ordre de 7 degrés.

Les charnières de pivotement 155A desdites barrettes 155 sont formées par des coudes reliant ces dernières auxdits bords de la plate-forme intermédiaire 151B.

La languette de manœuvre 153B comporte une largeur légèrement inférieure à celle de la languette rigide 153 qui la porte et qui forme la partie proximale de l'élément de fixation 150. Cette largeur est par exemple de l'ordre de 4 millimètres.

Enfin, le module d'appareillage 10 représenté sur la figure 1 comporte une rondelle de finition 160 à rapporter sur la face avant 111 du rebord 110 du support d'appareillage 100, autour de la collerette externe 211 du mécanisme d'appareillage 200, de manière à recouvrir complètement la face avant 111 ainsi que la tranche externe 110A de ce rebord 110 pour parfaire l'esthétique de l'ensemble.

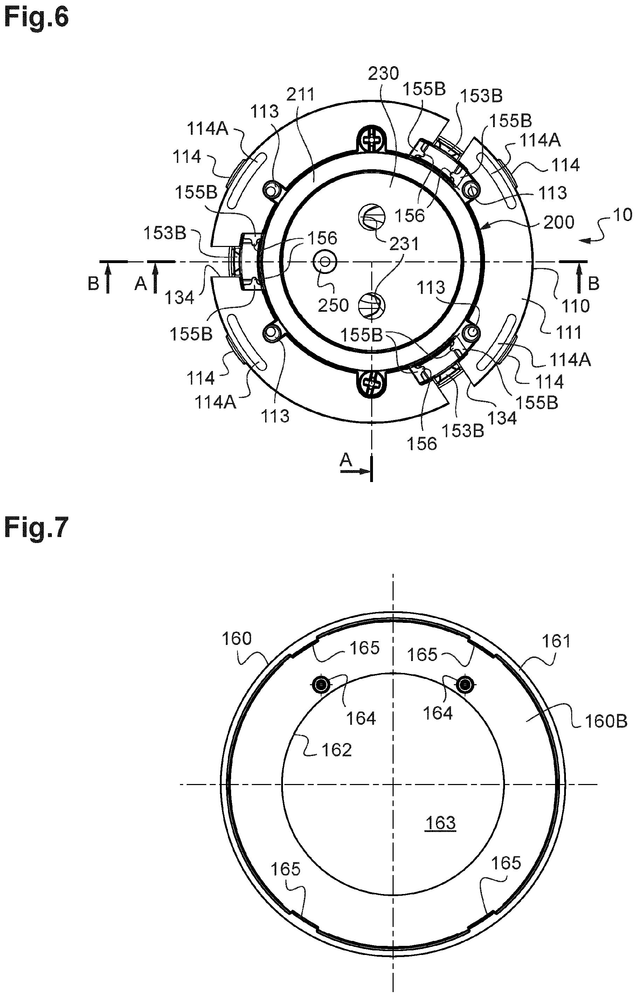

Comme le montre plus particulièrement la figure 7, cette rondelle de finition 160 comporte classiquement une ouverture centrale 163 délimitée par un bord interne circulaire 162. Cette ouverture centrale 163 présente un diamètre égal au jeu près au diamètre externe de la collerette externe 211 du mécanisme d'appareillage 200. La rondelle de finition 160 comporte un diamètre externe légèrement supérieur au diamètre externe du rebord 110 du support d'appareillage 100. Sa face avant annulaire 160A est bordée extérieurement par un bandeau 161 destiné à recouvrir la tranche externe 110A dudit rebord 110 du support d'appareillage 100. Le bord libre 161A de ce bandeau 161 porte quatre dents 165 s'étendant vers l'ouverture centrale 163 de la rondelle de finition 160. En correspondance, il est prévu sur la tranche externe 110A du rebord 110 du support d'appareillage 100, des crans 114 pour l'accrochage des dents 165 de la rondelle de finition 160. La face arrière 160B de la rondelle de finition 160 porte deux plots de centrage 164 et, en correspondance, le rebord 110 du support d'appareillage 100 comporte au moins deux ouvertures ou encoches circulaires 113 (ici quatre pour permettre une orientation de la rondelle de finition, notamment en cas de présence d'un marquage) accueillant ces plots 164.

Par ailleurs, comme le montrent les figures 4 et 5, il est préférentiellement prévu une rondelle 170 en matière rigide métallique ou plastique, engagée par l'arrière sur ladite paroi latérale 120 du support d'appareillage 100 contre la face arrière 112 dudit rebord 110 du support d'appareillage 100. Cette rondelle 170 présente une largeur supérieure à celle dudit rebord 110 de sorte qu'elle déborde de celui-ci. En fait, comme le montre la figure 5, cette rondelle 170 présente un diamètre interne légèrement supérieur au diamètre externe de la paroi latérale 120 et un diamètre externe identique ou légèrement supérieur à celui de la rondelle de finition 160. Avantageusement, la rondelle 170 est maintenue en position sur le support d'appareillage 100 par l'ensemble des deuxièmes dents 154A desdits éléments de fixation 150.

Nous allons décrire maintenant la mise en place du module d'appareillage 10 dans l'ouverture d'une paroi de réception P, dont la face avant P1 est revêtue d'un revêtement souple tel qu'un tissu (non représenté sur les figures).

La paroi latérale 120 du support d'appareillage 100 équipé de son mécanisme d'appareillage 200, mais non équipé de ses éléments de fixation 150, est engagée dans l'ouverture de cette paroi de réception P de sorte que la face arrière 112 du rebord 110 du support d'appareillage 100, prend appui sur la face avant P1 de cette paroi de réception P. La rondelle 170, préalablement enfilée par l'arrière sur la paroi latérale 120, permet avantageusement, lors de l'engagement de ladite paroi latérale 120, de comprimer le revêtement souple et éviter ainsi que celui-ci ne forme un bourrelet qui empêcherait le clippage de la rondelle de finition 160.

Comme le montrent les figurent 1 à 3, chaque élément de fixation 150 est engagé via l'extrémité avant 133 dans un conduit de guidage 130.

Lors de cet engagement, la languette rigide 151 formant la partie distale de l'élément de fixation 150, glisse entre les bords longitudinaux de l'ouverture latérale 134 de ce conduit de guidage 130 jusqu'à ce que la rampe d'engagement inclinée 152B de la première partie d'accroche 152, rencontre le bord avant de la partie 121 de la paroi latérale 120. Cette rampe d'engagement inclinée 152B force alors la partie distale 151 de l'élément de fixation 150 à glisser derrière cette partie 121 de paroi latérale jusqu'à ce que la première dent 152A qu'elle porte, s'accroche sur le cran 122 du conduit de guidage 130. De manière concomitante, la languette rigide 153 formant la partie proximale de l'élément de fixation 150 glisse entre les bords longitudinaux de l'ouverture latérale 134 de ce conduit de guidage 130. Lorsque la rampe d'engagement inclinée 154B de la deuxième partie d'accroche 154 rencontre le bord de l'ouverture de la paroi de réception P, celle-ci glisse sur ce bord et force ladite partie proximale 153 à fléchir vers l'intérieur du conduit de guidage 130 pour que la deuxième dent 154A que porte ladite partie proximale 153, passe sous ladite paroi de réception P. Lorsque cette deuxième dent 154A est passée sous la paroi de réception P, ladite partie proximale 153 revient élastiquement dans sa position d'origine, alignée avec la partie distale 151, et le coude formant la charnière de pivotement 153A de ladite partie proximale 153 vient en appui contre le bord avant de ladite partie 121 de la paroi latérale 120. Dans cette position, l'élément de fixation 150 est accroché et verrouillé dans le conduit de guidage 130 correspondant de la paroi latérale 120 du support d'appareillage 100 et la deuxième dent 154A que porte ladite partie proximale 153 prend appui contre la face arrière P2 de la paroi de réception P (voir figures 9 et 11). De manière concomitante également, les barrettes 155 de l'élément de fixation 150, glissent le long des faces latérales 132 en regard du conduit de guidage 130. Elles pivotent légèrement l'une vers l'autre, par flexion de leur charnière de pivotement 155B, en laissant un léger jeu 136 entre elles et lesdites faces latérales 132 du conduit de guidage 130. Dans la position complètement engagée dans le conduit d'engagement 130, les tétons 156 que portent les barrettes 155, se font face et se placent au droit de ladite languette de manœuvre 153B de la partie proximale 153 de l'élément de fixation 150 (voir figures 9 et 11).

Le support d'appareillage 100 du module d'appareillage 10 est alors fixé dans l'ouverture de la paroi de réception P prise en étau entre la face arrière 112 du rebord 110 du support d'appareillage 100 et les surfaces d'accrochage des deuxièmes dents 154A des éléments de fixation 150.

Il suffit alors de rapporter la rondelle de finition 160 sur le rebord 110 du support d'appareillage 100, autour de la partie fonctionnelle 230, 211 du mécanisme d'appareillage 200 pour parfaire l'esthétique de l'ensemble. Cette rondelle de finition 160 est centrée sur le rebord 110 par l'engagement de ses plots 164 dans les ouvertures 113 correspondantes du rebord 110 et elle s'accroche par ses dents 165 sur les crans 114 correspondants dudit rebord 110. Un évidement 114A en forme d'arc de cercle est réalisé au voisinage de chaque cran 114 pour favoriser le déplacement dudit cran 114 vers l'intérieur au passage de la dent 165 correspondante.

Pour retirer le module d'appareillage 10 de l'ouverture de la paroi de réception P, il suffit d'enlever la rondelle de finition 160 et de pousser la languette de manœuvre 153B de chaque élément de fixation 150 vers le fond du conduit de guidage 130 correspondant, à l'opposé de l'ouverture latérale 134, en allant jusqu'à la bloquer derrière les tétons 156 des barrettes 155 (voir figures 8 et 10). Dans cette position de retenue, la languette rigide 153 formant la partie proximale de chaque élément de fixation 150 est pivotée vers l'intérieur du conduit de guidage 130, par flexion de sa charnière de pivotement 153A, et la deuxième dent 152A qu'elle porte est retenue, en retrait de la face externe 120A de la paroi latérale 120 et de ladite ouverture latérale 134, à l'intérieur dudit conduit de guidage 130, désengagée de son appui contre la paroi de réception P (voir figures 8 et 10). Lorsque tous les élément de fixation 150 sont positionnés ainsi, hors de l'appui contre la paroi de réception, le support d'appareillage 100, équipé de ses éléments de fixation 150, maintenus en place sur celui-ci grâce à l'accrochage des premières dents 152A sur les crans 122 des conduits de guidage 130, peut être glissé aisément hors de l'ouverture de la paroi de réception P.

Ce module d'appareillage 10, une fois retiré, est éventuellement réutilisable en l'insérant, dans cet état « libéré » décrit ci-dessus, dans une nouvelle ouverture d'une paroi de réception jusqu'à ce que le rebord 110 de son support d'appareillage 100 s'appuie contre la paroi de réception, autour de l'ouverture. Il suffit alors de libérer, l'une après l'autre, les languettes de manoeuvre 153B, des tétons 156 des éléments de fixation 150, pour que, élastiquement, les parties proximale 153 pivotent vers leur position d'origine alignées avec les parties distales 151 correspondantes et que la deuxième dent 154A que porte chaque partie proximale 153 s'engage en appui sous la paroi de réception, en bloquant ainsi le support d'appareillage 100 dans ladite ouverture de la paroi de réception.

Si le support d'appareillage 100 décrit ici est avantageusement adapté au montage dans une paroi d'épaisseur proche du millimètre, il suffit de prévoir un autre jeu d'éléments de fixation dont la deuxième dent portée par la partie proximale est décalée vers l'arrière de quelques millimètres pour adapter un tel support d'appareillage au montage dans une paroi dont l'épaisseur est supérieure de quelques millimètres.

La présente invention n'est pas limitée au mode de réalisation décrit et représenté sur les différentes figures.

## Revendications

1. Support d'appareillage (100) destiné à être rapporté dans une ouverture d'une paroi de réception, qui comprend :
à l'avant, un rebord (110) défini entre une face avant (111) et une face arrière (112),
à l'arrière, une paroi latérale (120) qui s'étend à partir de la face arrière (112) dudit rebord (110), sur une certaine hauteur (H), cette paroi latérale comportant au moins un conduit de guidage (130) s'étendant sur au moins une partie de la hauteur de ladite paroi latérale, ledit conduit de guidage (130) présentant une extrémité avant (133) ouverte sur la face avant (111) dudit rebord (110) et, à l'opposé de ladite extrémité avant, une extrémité arrière (135) éloignée dudit rebord (110), et
au moins un élément de fixation (150) destiné à être enfilé dans ledit conduit de guidage (130), comportant, d'une part, à partir d'une extrémité proximale (153B), une partie proximale (153) qui se prolonge par une partie distale (151) s'étendant jusqu'à une extrémité distale (151A) , ladite partie proximale (153) étant apte à fléchir par rapport à ladite partie distale (151), et, d'autre part, une première partie d'accroche (152) pour sa fixation audit support d'appareillage ainsi qu'une deuxième partie d'accroche (154) pour sa fixation à ladite paroi de réception,
support d'appareillage dans lequel
chaque conduit de guidage comporte un cran (122) situé à proximité de son extrémité arrière (135) et une ouverture latérale (134) située au moins à proximité de son extrémité avant (133), juste en dessous de la face arrière (112) dudit rebord (110),
dans lequel
chaque élément de fixation (150) est une sorte d'agrafe allongée suivant un axe X comprenant une plate-forme rigide intermédiaire (151B) présentant, d'une part, une face arrière à laquelle est attachée de manière rigide la partie distale (151) qui est une pièce allongée qui s'étend selon l'axe X à partir de ladite face arrière perpendiculairement à celle-ci, et, d'autre part, un bord auquel est raccordée par une charnière de pivotement (153A) la partie proximale (153) qui est une pièce allongée qui s'étend selon l'axe X à partir dudit bord en porte-à-faux de ladite plate-forme rigide intermédiaire (151B),
dans lequel
ladite première partie d'accroche (152) de chaque élément de fixation comporte une première dent (152A) portée par ladite partie distale (151) à proximité immédiate de ladite extrémité distale (151A) et la deuxième partie d'accroche (154) de chaque élément de fixation comporte une deuxième dent (154A) portée par ladite partie proximale (153) à proximité immédiate de ladite extrémité proximale (153B), chaque élément de fixation (150) étant adapté à être enfilé dans chaque conduit de guidage (130) via ladite extrémité avant (133) de celui-ci de sorte que ladite première dent (152A) dudit élément de fixation s'accroche audit cran (122) dudit conduit de guidage (130) et que ladite deuxième dent (154A) dudit élément de fixation (150) fait saillie sur ladite paroi latérale (120) du support d'appareillage (100), au travers de ladite ouverture latérale (134) dudit conduit de guidage, à un niveau situé selon l'axe X en dessous et à proximité de la face arrière (112) dudit rebord (110),
et dans lequel
chaque élément de fixation (150) comporte, d'une part, deux barrettes (155) rigides qui s'étendent globalement dans la même direction que la partie proximale (153), à partir de deux autres bords parallèles de ladite plate-forme rigide intermédiaire (151B), en étant reliées à ceux-ci par des charnières de pivotement (155A), chaque barrette (155) portant un téton (156) sur une face en regard de l'autre barrette (155), et, d'autre part, une languette de manœuvre (153B) formant ladite extrémité proximale (153B) de ladite partie proximale (153), les tétons (156) portés par lesdites barrettes (155) étant aptes à s'appliquer contre ladite languette de manœuvre (153B) lors d'une flexion de la charnière de pivotement (153A) de ladite partie proximale (153) et desdites charnières de pivotement (155A) desdites barrettes (155) pour maintenir la deuxième dent (154A) de chaque élément de fixation en retrait de la face externe (120A) de ladite paroi latérale (120).

2. Support d'appareillage (100) selon la revendication 1, dans lequel la partie distale (151) et la partie proximale (153) de chaque élément de fixation (150) sont deux languettes rigides dont des faces orientées d'un même côté portent, respectivement, les première et deuxième dents (152A,154A), chacune des première et deuxième dents étant raccordée à ladite face de la languette correspondante par une rampe d'engagement inclinée (152B, 154B).

3. Support d'appareillage (100) selon l'une des revendications précédentes, dans lequel les deux barrettes (155) s'étendent suivant deux axes Y1 et Y2 inclinés par rapport audit axe X et formant un angle aigu entre eux.

4. Support d'appareillage (100) selon l'une quelconque des revendications précédentes, dans lequel chaque élément de fixation (150) est une pièce monobloc réalisée par moulage d'une matière plastique.

5. Support d'appareillage (100) selon l'une quelconque des revendications précédentes, dans lequel chaque conduit de guidage (150) est formé par une rainure ouverte latéralement sur la face externe (120A) de ladite paroi latérale (120).

6. Support d'appareillage (100) selon la revendication précédente, dans lequel ladite ouverture latérale (134) de chaque rainure comprend deux parties séparées par une partie (121) de ladite paroi latérale (120), à savoir une partie avant (134A) s'étendant depuis l'extrémité avant de ladite rainure jusqu'à un bord avant de cette partie (121) de ladite paroi latérale (120) et une partie arrière (134B) s'étendant depuis un bord arrière de cette partie de ladite paroi latérale jusqu'à l'extrémité arrière de ladite rainure, ledit bord arrière (122) formant ledit cran sur lequel s'accroche ladite première dent (152A) de l'élément de fixation (150) enfilé dans ladite rainure.

7. Support d'appareillage (100) selon l'une quelconque des revendications précédentes, dans lequel ladite paroi latérale comporte au moins deux conduits de guidage (130) positionnés de manière diamétralement opposé et accueillant deux éléments de fixation (150).

8. Support d'appareillage (100) selon la revendication précédente, dans lequel ladite paroi latérale comporte trois conduits de guidage (130) répartis régulièrement sur son pourtour et accueillant trois éléments de fixation (150).

9. Support d'appareillage (100) selon l'une quelconque des revendications précédentes, dans lequel il est prévu une rondelle (170) engagée par l'arrière sur ladite paroi latérale contre la face arrière dudit rebord, cette rondelle présentant une largeur supérieure à celle dudit rebord (110) de sorte qu'elle déborde de celui-ci.

10. Support d'appareillage (100) selon la revendication précédente, dans lequel la rondelle (170) est maintenue en position sur le support d'appareillage (100) par l'ensemble des deuxièmes dents (154A) desdits éléments de fixation (150)

11. Module d'appareillage (10) comportant un support d'appareillage (100) selon l'une quelconque des revendications précédentes et au moins un mécanisme d'appareillage (200) monté dans ledit support d'appareillage (100) de sorte qu'une partie fonctionnelle (230) de chaque mécanisme d'appareillage est entourée par le rebord (110) de ce dernier.

## Patentansprüche

1. Gerätehalterung (100), die dazu bestimmt ist, in eine Öffnung einer Aufnahmewand eingesetzt zu werden, und die folgendes aufweist:
vorne einen zwischen einer Vorderseite (111) und einer Rückseite (112) definierten Rand (110),
hinten eine Seitenwand (120), die sich von der Rückseite (112) des Rands (110) über eine gewisse Höhe (H) erstreckt, wobei diese Seitenwand mindestens einen sich über mindestens einen Teil der Höhe der Seitenwand erstreckenden Führungskanal (130) aufweist, wobei der Führungskanal (130) ein zur Vorderseite (111) des Rands (110) hin offenes vorderes Ende (133) und, vom vorderen Ende abgewandt, ein vom Rand (110) entferntes hinteres Ende (135) aufweist, und
mindestens ein Befestigungselement (150), das dazu bestimmt ist, in den Führungskanal (130) eingezogen zu werden, und das einerseits, von einem proximalen Ende (153B) ausgehend, einen durch einen distalen, sich bis zu einem distalen Ende (151A) erstreckenden distalen Teil (151) verlängerten proximalen Teil (153) aufweist, wobei der proximale Teil (153) geeignet ist, sich gegenüber dem distalen Teil (151) zu verbiegen, und andererseits einen ersten Einhakteil (152) für dessen Befestigung an der Gerätehalterung und einen zweiten Einhakteil (154) für dessen Befestigung an der Aufnahmewand aufweist,
Gerätehalterung, bei der
jeder Führungskanal eine in der Nähe seines hinteren Endes (135) gelegene Kerbe (122) und eine mindestens in der Nähe seines vorderen Endes (133), gerade unter der Rückseite (112) des Rands (110) gelegene seitliche Öffnung (134), aufweist,
bei der
jedes Befestigungselement (150) eine Art sich entlang einer X-Achse erstreckende Klammer mit einer steifen Zwischenplattform (151B) ist, die einerseits eine Rückseite, an der der distale Teil (151) steif befestigt ist, der ein längliches Teil ist, das sich von der Rückseite aus senkrecht zu dieser in der X-Achsenrichtung erstreckt, und andererseits einen Rand, an dem durch ein Schwenkscharnier (153A) der proximale Teil (153) befestigt ist, der ein längliches Teil aufweist, das sich von dem seitlich versetzten Rand der steifen Zwischenplattform (151B) aus in der X-Achsenrichtung erstreckt, aufweist,
bei der
der erste Einhakteil (152) jedes Befestigungselements einen vom ersten distalen Teil (151) in unmittelbarer Nähe des distalen Endes (151A) getragenen ersten Zahn (152A) aufweist und der zweite Einhakteil (154) jedes Befestigungselements einen vom ersten proximalen Teil (153) in unmittelbarer Nähe des proximalen Endes (153B) getragenen zweiten Zahn (154A) aufweist, wobei jedes Befestigungselement (150) dazu ausgelegt ist, in jeden Führungskanal (130) über dessen vorderes Ende (133) eingeführt zu werden, damit sich der erste Zahn (152A) des Befestigungselements an der Kerbe (122) des Führungskanals (130) festhakt und damit der zweite Zahn (154A) des Befestigungselements (150) aus der Seitenwand (120) der Gerätehalterung (100) durch die seitliche Öffnung (134) des Führungskanals auf einer Höhe entlang der X-Achse unterhalb und in der Nähe der Rückseite (112) des Rands (110) hervortritt,
und bei der
jedes Befestigungselement (150) einerseits zwei steife Spangen (155), die sich im Wesentlichen in der gleichen Richtung wie der proximale Teil (153) von zwei anderen parallelen Rändern der steifen Zwischenplattform (151B) aus erstrecken und dabei mit selbigen durch Schwenkscharniere (155) verbunden sind, wobei jede Spange (155) auf einer gegenüber der anderen Spange (155) liegenden Seite einen Nippel (156) hat, und andererseits eine das proximale Ende (153B) des proximalen Teils (153) bildende Betätigungszunge (153B) aufweist, wobei die von den Spangen (155) getragenen Nippel (156) dazu geeignet sind, bei einem Biegen des Schwenkscharniers (153A) des proximalen Teils (153) und der Schwenkscharniere (155A) der Spangen (155) an der Betätigungszunge (153B) anzuliegen, um den zweiten Zahn (154A) jedes Befestigungselements gegenüber der Außenseite (120A) der Seitenwand (120) zurückgezogen zu halten.

2. Gerätehalterung (100) gemäß Anspruch 1, bei der der distale Teil (151) und der proximale Teil (153) jedes Befestigungselements (150) zwei steife Zungen sind, deren in einer selben Richtung ausgerichtete Seiten den ersten beziehungsweise den zweiten Zahn (152A, 154A) tragen, wobei der erste und der zweite Zahn jeweils über eine geneigte Einführungsrampe (152B, 154B) mit der entsprechenden Seite der Zunge verbunden sind.

3. Gerätehalterung (100) gemäß einem der vorangehenden Ansprüche, bei der sich die beiden Spangen (155) entlang zweier gegenüber der X-Achse geneigter und einen spitzen Winkel miteinander bildender Achsen Y1 und Y2 erstrecken.

4. Gerätehalterung (100) gemäß einem der vorangehenden Ansprüche, bei der jedes Befestigungselement (150) ein einstückiges, durch Gießen eines Plastikmaterials hergestelltes Teil ist.

5. Gerätehalterung (100) gemäß einem der vorangehenden Ansprüche, bei der jeder Führungskanal (150) durch eine seitlich offene Rille auf der Außenseite (120A) der Seitenwand (120) gebildet ist.

6. Gerätehalterung (100) gemäß dem vorangehenden Anspruch, bei der die seitliche Öffnung (134) jeder Rille zwei durch einen Teil (121) der Seitenwand (120) getrennte Teile aufweist, und zwar einen vorderen Teil (134A), der sich vom vorderen Ende der Rille bis zu einem vorderen Rand dieses Teils (121) der Seitenwand (120) erstreckt, und einen hinteren Teil (134B), der sich von einem hinteren Rand dieses Teils der Seitenwand bis zum hinteren Ende der Rille erstreckt, wobei der hintere Rand (122) die besagte Kerbe bildet, an der der erste Zahn (152A) des in die Rille eingezogenen Befestigungselements (150) einhakt.

7. Gerätehalterung (100) gemäß einem der vorangehenden Ansprüche, bei der die Seitenwand mindestens zwei Führungskanäle (130) aufweist, die diametral gegenüberliegend angeordnet sind und zwei Befestigungselemente (150) aufnehmen.

8. Gerätehalterung (100) gemäß dem vorangehenden Anspruch, bei der die Seitenwand drei Führungskanäle (130) aufweist, die gleichmäßig über deren Umfang verteilt sind und drei Befestigungselemente (150) aufnehmen.

9. Gerätehalterung (100) gemäß einem der vorangehenden Ansprüche, bei der eine ringförmige Scheibe (170) vorgesehen ist, die von hinten auf die Seitenwand und gegen die Rückseite des Rands aufgesetzt ist, wobei die ringförmige Scheibe eine größere Breite als die Breite des Rands (110) hat, damit sie über letzteren hinausragt.

10. Gerätehalterung (100) gemäß dem vorangehenden Anspruch, bei der die ringförmige Scheibe (170) durch die Gesamtheit der zweiten Zähne (154A) der Befestigungselemente (150) auf der Gerätehalterung (100) in Position gehalten wird.

11. Gerätemodul (10), das eine Gerätehalterung (100) gemäß einem der vorangehenden Ansprüche und mindestens einen Gerätemechanismus (200) aufweist, der in der Gerätehalterung (100) so montiert ist, daß ein Funktionsteil (230) jedes Gerätemechanismus vom Rand (110) des letzteren umgeben ist.

## Claims

1. Equipment support (100) intended to be inserted in an opening of a receiving wall, comprising:
at the front, a rim (110) defined between a front face (111) and a rear face (112),
at the rear, a side wall (120) that extends from the rear face (112) of said rim (110) over a certain height (H), this side wall comprising at least one guide duct (130) that extends over at least part of the height of said side wall, said guide duct (130) having a front end (133) that is open to the front face (111) of said rim (110) and, opposite said front end, a rear end (135) that is remote from said rim (110), and
at least one fastening element (150) intended to be inserted into said guide duct (130) and comprising, firstly, starting from a proximal end (153B),
a proximal portion (153) that is extended by a distal portion (151) extending up to a distal end (151A), said proximal portion (153) being capable of bending with respect to said distal portion (151), and, secondly, a first hooking portion (152) for fastening to said equipment support and a second hooking portion (154) for fastening to said receiving wall,
wherein
each guide duct comprises a notch (122) located close to its rear end (135) and a side opening (134) located at least close to its front end (133), just below the rear face (112) of said rim (110),
wherein
each fastening element (150) is a kind of clip that is elongate along an axis X, comprising an intermediate rigid platform (151B) having, firstly, a rear face to which the distal portion (151), which is an elongate part extending along the axis X from said rear face perpendicularly thereto, is rigidly attached, and, secondly, an edge to which the proximal portion (153), which is an elongate part extending along the axis X from said edge in a manner overhanging said intermediate rigid platform (151B), is joined by a pivot hinge (153A),
wherein
said first hooking portion (152) of each fastening element comprises a first tooth (152A) borne by said distal portion (151) in the immediate vicinity of said distal end (151A), and the second hooking portion (154) of each fastening element comprises a second tooth (154A) borne by said proximal portion (153) in the immediate vicinity of said proximal end (153B), each fastening element (150) being suitable for being inserted into each guide duct (130) via said front end (133) thereof such that said first tooth (152A) of said fastening element hooks to said notch (122) of said guide duct (130), and such that said second tooth (154A) of said fastening element (150) projects from said side wall (120) of the equipment support (100), through said side opening (134) of said guide duct, at a level located below and close to the rear face (112) of said rim (110) along the axis X,
and wherein
each fastening element (150) comprises, firstly, two rigid bars (155) that extend generally in the same direction as the proximal portion (153) from two other parallel edges of said intermediate rigid platform (151B) while being connected to said edges by pivot hinges (155A), each bar (155) bearing a stud (156) on a face facing the other bar (155), and, secondly, an operating tab (153B) forming said proximal end (153B) of said proximal portion (153), the studs (156) borne by said bars (155) being engageable against said operating tab (153B) when the pivot hinge (153A) of said proximal portion (153) and said pivot hinges (155A) of said bars (155) bend, so as to keep the second tooth (154A) of each fastening element set back from the external face (120A) of said side wall (120).

2. Equipment support (100) according to claim 1, wherein the distal portion (151) and the proximal portion (153) of each fastening element (150) are two rigid tabs whose faces oriented on the same side bear the first and second teeth (152A, 154A), respectively, each of the first and second teeth being joined to said face of the corresponding tab by an inclined engagement ramp (152B, 154B).

3. Equipment support (100) according to any of the preceding claims, wherein the two bars (155) extend along two axes Y1 and Y2 which are inclined with respect to said axis X and which form an acute angle between them.

4. Equipment support (100) according to any of the preceding claims, wherein each fastening element (150) is a single-piece part produced by moulding a plastics material.

5. Equipment support (100) according to any of the preceding claims, wherein each guide duct (150) is formed by a groove that is open laterally to the external face (120A) of said side wall (120).

6. Equipment support (100) according to the preceding claim, wherein said side opening (134) of each groove comprises two portions separated by a portion (121) of said side wall (120), namely a front portion (134A) extending from the front end of said groove up to a front edge of said portion (121) of said side wall (120), and a rear portion (134B) extending from a rear edge of said portion of said side wall up to the rear end of said groove, said rear edge (122) forming said notch onto which said first tooth (152A) of the fastening element (150) inserted into said groove hooks.

7. Equipment support (100) according to any of the preceding claims, wherein said side wall comprises at least two guide ducts (130) which are positioned diametrically opposite each other and which receive two fastening elements (150).

8. Equipment support (100) according to the preceding claim, wherein said side wall comprises three guide ducts (130) which are regularly distributed around its periphery and which receive three fastening elements (150).

9. Equipment support (100) according to any of the preceding claims, wherein a washer (170) engaged by the rear on said side wall against the rear face of said rim is provided, said washer having a width greater than that of said rim (110), such that it projects therefrom.

10. Equipment support (100) according to the preceding claim, wherein the washer (170) is held in position on the equipment support (100) by all of the second teeth (154A) of said fastening elements (150).

11. Equipment module (10) comprising an equipment support (100) according to any of the preceding claims and at least one equipment mechanism (200) mounted in said equipment support (100) such that a functional portion (230) of each equipment mechanism is enclosed by the rim (110) thereof.
